Europäisches Patentamt

European Patent Office

Office européen des brevets

(19)

(11) EP 0 896 732 B1

(12) **EUROPÄISCHE PATENTSCHRIFT**

(45) Veröffentlichungstag und Bekanntmachung des Hinweises auf die Patenterteilung:
**14.11.2001 Patentblatt 2001/46**

(51) Int Cl.⁷: **H01J 37/34**

(21) Anmeldenummer: **97922892.1**

(86) Internationale Anmeldenummer:
**PCT/DE97/00876**

(22) Anmeldetag: **29.04.1997**

(87) Internationale Veröffentlichungsnummer:
**WO 97/41587 (06.11.1997 Gazette 1997/47)**

(54) **SPUTTERANLAGE MIT ZWEI LÄNGSERSTRECKTEN MAGNETRONS**

SPUTTERING INSTALLATION WITH TWO LONGITUDINALLY PLACED MAGNETRONS

INSTALLATION A PULVERISATION CATHODIQUE A DEUX MAGNETRONS LONGITUDINAUX

(84) Benannte Vertragsstaaten:
**AT BE CH ES FI FR GB GR IT LI NL SE**

(30) Priorität: **29.04.1996 DE 19617057**

(43) Veröffentlichungstag der Anmeldung:
**17.02.1999 Patentblatt 1999/07**

(73) Patentinhaber: **VON ARDENNE ANLAGENTECHNIK GmbH**
**01324 Dresden (DE)**

(72) Erfinder:
• **STRÜMPFEL, Johannes**
**D-01277 Dresden (DE)**
• **BEISTER, Günter**
**D-01326 Dresden (DE)**
• **ERBKAMM, Wolfgang**
**D-01257 Dresden (DE)**
• **REHN, Stanley**
**D-01099 Dresden (DE)**

(74) Vertreter: **Adler, Peter, Dipl.-Ing. et al**
**Patentanwälte**
**Lippert, Stachow, Schmidt & Partner**
**Krenkelstrasse 3**
**01309 Dresden (DE)**

(56) Entgegenhaltungen:
**EP-A- 0 450 163        EP-A- 0 502 242**
**WO-A-95/12003          US-A- 5 382 344**
**US-A- 5 458 759**

**Beschreibung**

Die Erfindung betrifft eine Sputteranlage mit zwei längserstreckten Magnetrons, die nebeneinander angeordnet sind und auf ihrer Oberseite je ein Target aufweisen. Unter dem Target befindet sich ein U-förmiger Grundkörper mit darin eingeschlossenen Magneten, bestehend aus außen- und innenliegenden Magneten. Dabei liegt zwischen einer Masse und dem einem Target eine positive Spannung und zwischen der Masse und dem anderen Target eine negative Spannung an.

Es sind Sputteranlagen mit derart nebeneinanderliegenden längserstreckten Magnetrons aus der Europäischen Patentanmeldung 0 502 242 A2 bekannt. Darin ist eine Vorrichtung zum reaktiven Beschichten eines Substrats beschrieben, bei dem zwei benachbarte längserstreckte Magnetrons eingesetzt werden. Dabei liegen den zu beschichtenden Substraten die Targets gegenüber, die zu zerstäuben sind. Jedes Target ist mit einem Kathodenkörper verbunden, der ein Magnetjoch aufnimmt, das jeweils drei Magnete aufweist. Die auf die Targets gerichteten Pole der Magnete wechseln sich ab, so daß diese etwa kreisbogenförmige Magnetfelder durch die Targets bewirken. Dadurch wird ein Plasma vor den Targets verdichtet, welches ein Herauslösen von Ionen bewirkt, die sich durch ein elektrisches Feld beschleunigt, auf den Substraten abscheiden. Bei diesem Sputtervorgang wird von dem Target nicht gleichmäßig das Material abgetragen, sondern es entsteht vielmehr ein sogenannter Erosionsgraben. Die Linie der tiefsten Stellen dieses Erosionsgrabens wird als Leitlinie bezeichnet.

In diesen Anlagen kann das Target einstückig ausgeführt sein oder aus mehreren Teilstücken bestehen, wobei der letzteren Variante der Vorzug gegeben wird.

Ein Target ist dann als verbraucht anzusehen, wenn der Erosionsgraben auch nur an einer Stelle des Targets so tief ist, daß die Materialdicke an dieser Stelle einen Schwellwert unterschreitet. Aus diesem Grunde ist man bestrebt, den Erosionsgraben nach Möglichkeit sehr breit zu gestalten und dafür Sorge zu tragen, daß er eine gleichmäßige Tiefe aufweist.

Bei den genannten Sputteranlagen mit zwei längserstreckten Magnetrons hat es sich jedoch gezeigt, daß an je einem Ende des Targets der Erosionsgraben wesentlich tiefer ist als in anderen Bereichen. Infolge dieser tieferen Erosion sind die Targets wesentlich schneller verbraucht.

Durch den Aufbau derartiger Magnetrons mit äußeren und inneren Magneten entsteht ein längserstrecktes aber ringförmiges Magnetfeld.

Die Targetspannungen an den Magnetron werden unterschiedlich gepolt, das heißt zu einem Zeitpunkt wird an das eine Target eine zu einer Masse positive Spannung und an des andere Target eine zu der Masse negative Spannung angelegt. Die Targetspannungen und die ringförmigen Magnetfelder bewirken ringförmige Elektronenströme in den Targets. Zu einem darauffolgenden Zeitpunkt erfolgt eine Polaritätswechsel beider Spannungen. Die Richtungen der Elektronenströme innerhalb des Targets werden durch die Polungen der Magnetanordnungen bestimmt.

Es hat sich nunmehr gezeigt, daß die Stellen, in denen eine stärkere Vertiefung des Erosionsgrabens eintritt, genau an den Enden des Magnetrons liegen, an denen die Elektronenströme auf das jeweils andere Magnetron hin gerichtet sind.

Die Aufgabe der Erfindung besteht nunmehr darin, die Ausnutzung von Targets in Sputteranlagen mit nebeneinander liegenden Magnetrons zu erhöhen.

Gemäß der Erfindung wird die Aufgabe dadurch gelöst, daß der Entladungswiderstand eines Magnetron längs der Leitlinie derart homogenisiert ist, daß ein partieller Entladungswiderstand eines Targetpunktes auf der Leitlinie die gleiche Größe aufweist, wie der partielle Entladungswiderstand eines anderen Targetpunktes auf der Leitlinie, indem zwischen den beiden Magnetron eine Trennwand aus weichmagnetischem Material angeordnet ist und/oder indem zwischen die außenliegenden und die innenliegenden Magnete an sich bekannte Shunts, das heißt Einlagen aus weichmagnetischen Material, eingebracht sind, wobei der Shunt auf der dem jeweils anderen Magnetron naheliegenden Seite im Verhältnis zu dem Shunt auf der dem jeweils anderen Magnetron abgewandten Seite eine größere Breite aufweist.

Der Entladungswiderstand des gesamten Magnetron bestimmt sich aus dem Quotienten von Targetspannung zu dem Targetstrom. Infolge der flächenhaften Verteilung des Targets erfährt dieser Entladungswiderstand auch eine Verteilung auf dem gesamten Target, so daß sich der Entladungswiderstand im eigentlichen aus der Summe einer Vielzahl von partiellen Entladungswiderständen ergibt.

Mit einer Homogenisierung des Entladungswiderstandes längs der Leitlinie hat es sich nunmehr gezeigt, daß damit die Vertiefung des Erosionsgrabens an den Enden, wo die Elektronenströme auf das jeweils andere Magnetron zuweisen, erheblich verringert werden kann.

Die Erfindung soll nachfolgend anhand eines Ausführungsbeispieles näher erläutert werden. In den zugehörigen Zeichnungen zeigt

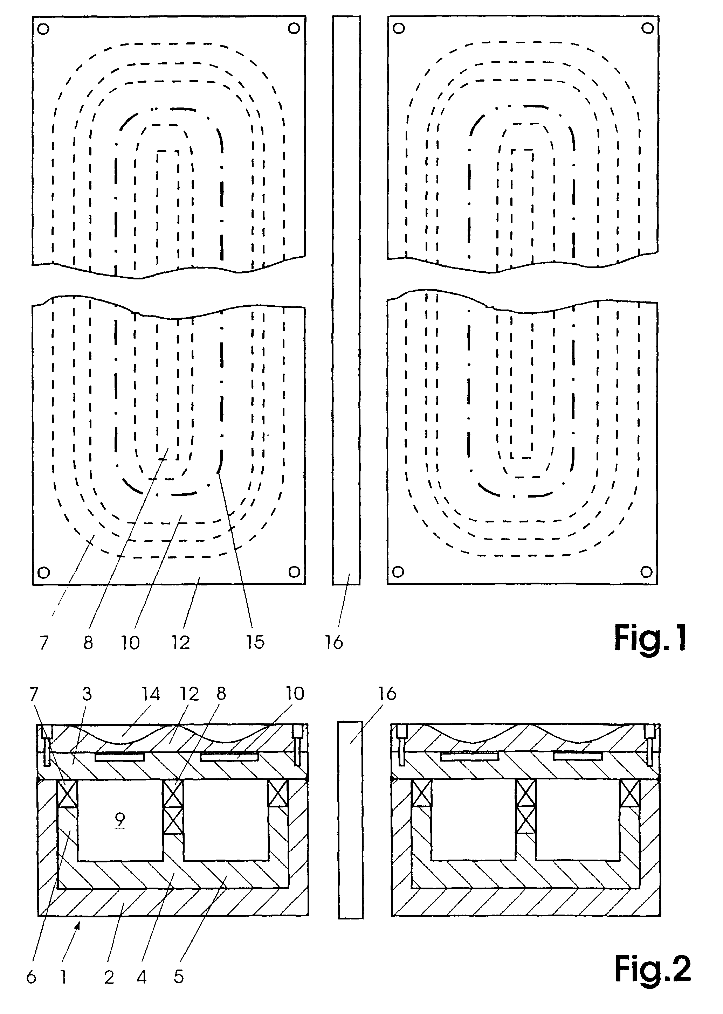

Fig. 1 eine Draufsicht auf eine erfindungsgemäße Sputteranlage,

Fig. 2 einen Querschnitt durch eine erfindungsgemäße Sputteranlage und

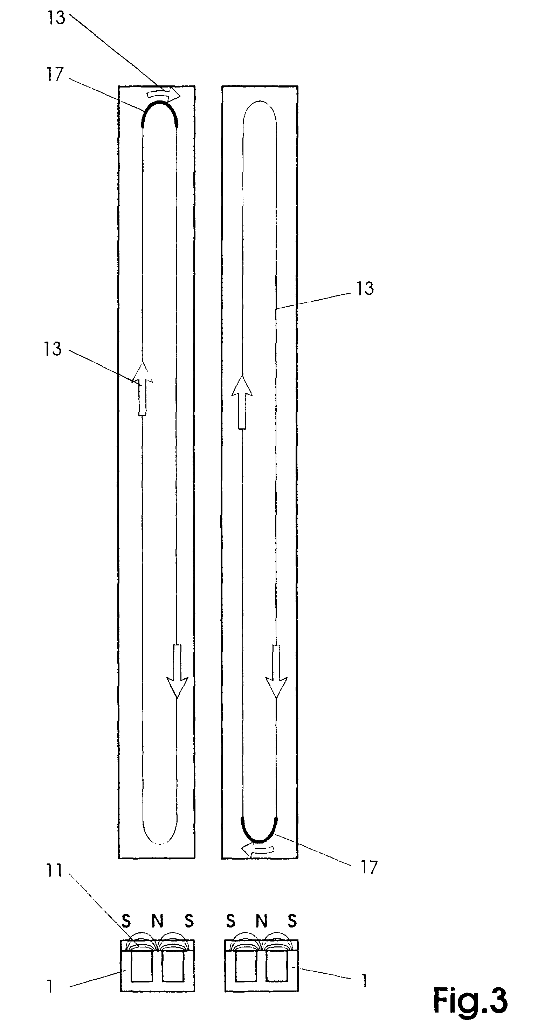

Fig. 3 eine Prinzipdarstellung des Magnetfeldlinien- und Elektronenflußverlaufes.

Die erfindungsgemäße Sputteranlage besteht aus zwei längserstreckten Magnetrons 1, die nebeneinander angeordnet sind. Ein Magnetron 1 besteht aus einem U-förmigen Grundkörper 2, der an seiner Oberseite mit einer Kühlplatte 3 verschlossen ist. Der Grundkörper 2 schließt Magnetkernelemente 4 ein. Diese Magnetkernelemente 4 bestehen aus einem waagerecht liegenden Grundelement 5 und auf diesem Grundelement 5 stehenden Stützelementen 6. An der Oberseite der Stützelemente 6 sind außenliegende Magnete 7 und innenliegende Magnete 8 angeordnet. Von dem Grundelement 5, den Stützelementen 6 und der Kühlplatte 3 wird ein Hohlraum 9 gebildet, der der Aufnahme von Kühlmittel zur Ableitung von Wärme aus der Kühlplatte 3 dient.

Innerhalb der Kühlplatte 3 sind Shunts 10 angeordnet. Diese Shunts 10 stellen weichmagnetische Einlagen dar und liegen im Bereich des Magnetfeldes 11 zwischen den außen- und innenliegenden Magneten 7 und 8. Dieses Magnetfeld 11 durchdringt auch das auf der Kühlplatte 3 aufliegende und an dieser befestigte Target 12.

Zwischen dem Target 12 und einer nicht näher dargestellten elektrischen Masse wird eine Targetspannung angelegt. Infolge des Magnetfeldes 11 kommt es innerhalb des Targets 12 zu einem Elektronenfluß 13, dessen Richtung sich nach der Polung der Magnete 7 und 8 bestimmt.

Bei dem Sputterprozeß entstehen innerhalb des Target 12 Erosionsgräben 14. Die Verbindung der tiefsten Punkte der Erosionsgräben 14 stellt die Leitlinie 15 dar.

Dadurch, daß der Shunt 10 an der Seite eines Magnetron 1, die dem jeweils anderen Magnetron 1 gegenüberliegt, breiter ausgebildet ist, als der Shunt auf der jeweils abgewandten Seite des Magnetron und durch eine zwischen die beiden Magnetron 1 eingebrachte Trennwand 16 aus weichmagnetischen Material wird die gegenseitige Beeinflussung der Magnetfelder 11 soweit minimiert, daß der Entladungswiderstand entlang der Leitlinie 15 homogenisiert wird. Der Entladungswiderstand $R_E$ ergibt sich aus

$$R_E \quad \sum_{i\ 1}^{i\cdot n} R_{E_i}$$

wobei $R_{Ei}$ einen partiellen Ladungswiderstand an einem Punkt auf dem Target darstellt. $R_E$ selbst errechnet sich zu

$$R_E \quad \frac{U_T}{I_E}$$

wobei $U_T$ die Targetspannung und $I_E$ der Entladungsstrom ist. Aus diesen Beziehungen zeigt es sich, daß eine Homogenisierung des Entladungswiderstandes $R_E$ entlang der Leitlinie 15 bedeutet, daß die partiellen Entladungswiderstände $R_{Ei}$ an jedem Punkt des Targets auf der Leitlinie den annähernd gleichen Wert eines anderen Punktes des Targets 12 auf der Leitlinie 15 aufweisen.

Durch die Homogenisierung des Entladungswiderstandes $R_E$ wird erreicht, daß der Erosionsgraben 14 in den gefährdeten Targetbereichen 17, in denen nämlich der Elektronenfluß 13 eines Magnetrons 1 auf das jeweils benachbarte Magnetron 1 gerichtet ist, nicht tiefer entsteht als in den übrigen Targetbereichen. Durch eine weitgehend gleichmäßige Tiefe des Erosionsgrabens 14 wird somit ermöglicht, die Targetauslastung gegenüber dem Stand der Technik, bei dem in dem gefährdeten Targetbereich 17 eine Vertiefung des Erosionsgrabens 14 eintreten würde, erhöht wird.

**Sputteranlage mit zwei längserstreckten Magnetrons**

**Bezugszeichenliste**

| | |
|---|---|
| 1 | Magnetron |
| 2 | Grundkörper |
| 3 | Kühlplatte |
| 4 | Magnetkernelement |
| 5 | Grundelement |
| 6 | Stützelement |
| 7 | außenliegender Magnet |
| 8 | innenliegender Magnet |
| 9 | Hohlraum |
| 10 | Shunt |
| 11 | Magnetfeld |
| 12 | Target |
| 13 | Elektronenfluß |
| 14 | Erosionsgraben |
| 15 | Leitlinie |
| 16 | Trennwand |
| 17 | gefährdeter Targetbereich |
| $R_E$ | Entladungswiderstand |
| $R_{Ei}$ | partieller Entladungswiderstand |
| $U_T$ | Targetspannung |
| $I_E$ | Entladungsstrom |

**Patentansprüche**

1. Sputteranlage mit zwei längserstreckten Magnetrons, die nebeneinander angeordnet sind und auf ihrer Oberseite je ein Target aufweisen, unter dem sich ein U-förmiger Grundkörper mit darin eingeschlossenen Magneten, bestehend aus außen- und innenliegenden Magneten befindet, wobei zwischen einer Masse und dem einen Target eine positive Spannung und zwischen der Masse und dem anderen Target eine negative Targetspannung angelegt ist, **dadurch gekennzeichnet, daß** der Entladungswiderstand ($R_E$) eines Magnetron (1) längs der Leitlinie (15) derart homogenisiert ist, daß ein partieller Entladungswiderstand ($R_{Ei}$) eines Targetpunktes auf der Leitlinie (15) die gleiche Größe aufweist, wie der partielle Entladungswiderstand ($R_{Ei}$) eines anderen Targetpunktes auf der Leitlinie (15), indem zwischen den beiden Magnetron (1) eine Trennwand (16) aus weichmagnetischem Material angeordnet ist und/oder indem zwischen die außenliegenden und die innenliegenden Magnete an sich bekannte Shunts (10), das heißt Einlagen aus weichmagnetischen Material, eingebracht sind, wobei der Shunt (10) auf der dem jeweils anderen Magnetron (1) naheliegenden Seite im Verhältnis zu dem Shunt (10) auf der dem jeweils anderen Magnetron (1) abgewandten Seite eine größere Breite aufweist.

## Claims

1. Sputter Equipment with two magnetrons extended lengthwise, arranged alongside each other and each provided on its upper side with a target, beneath which a U-formed body with enclosed magnets, consisting of outer and inner magnets is located, whereby between a chassis connection and one target a positive potential is applied and between chassis and the other target a negative potential is applied thereby causing a discharge resistor $R_E$ of a magnetron (1) along the conducting path (15) to be homogenized in such a manner that a partial discharge resistor ($R_{EI}$) of a target point on the conducting line (15) displays the same magnitude as the partial discharge resistor ($R_{EI}$) of another different target point on the conducting line (15), while between the two magnetrons (1) a dividing wall (16) of soft magnetic material is arranged and /or simultaneously between the outer and inner located magnets, previously known shunts (10) that is, arrangements composed of soft magnetic materials, are mounted, whereby each shunt (10) on the side adjacent to the other magnetron, in comparison with the shunt (10) on the away facing side of the other magnetron (1) displays a greater width.

## Revendications

1. Système de pulvérisation avec deux magnétrons longitudinaux qui sont juxtaposés et qui présentent chacun sur leur côté supérieur une cible sous laquelle se trouve un corps de base en forme de U renfermant des aimants composés d'aimants situés à l'intérieur et à l'extérieur, sachant qu'il est appliqué une tension positive entre une masse et l'une des cibles et une tension négative entre la masse et l'autre cible,
**caractérisé en ce que** la résistance à la décharge ($R_E$) d'un magnétron (1) est homogénéisée le long de la ligne directrice (15) de manière à ce qu'une résistance partielle à la décharge ($R_{Ei}$) d'un point de la cible sur la ligne directrice (15) présente la même ampleur que la résistance partielle à la décharge ($R_{Ei}$) d'un autre point de la cible sur la ligne directrice (15), par le fait qu'une paroi de séparation (16) en matériau magnétique doux est disposée entre les deux magnétrons (1) et/ou par le fait que des shunts (10) connus, c'est-à-dire des pièces intercalaires en matériau magnétique doux, sont disposés entre les aimants situés à l'extérieur et ceux situés à l'intérieur, sachant que le shunt (10) présente une largeur plus importante sur le côté proche de l'autre magnétron (1) respectivement comparativement au shunt (10) sur le côté opposé à l'autre magnétron respectivement.

Fig.1

Fig.2

**Fig.3**